Europäisches Patentamt

European Patent Office

Office européen des brevets

(19)

(11) Publication number: **0 205 284**
A2

## (12) EUROPEAN PATENT APPLICATION

(21) Application number: **86304098.6**

(22) Date of filing: **29.05.86**

(51) Int. Cl.⁴: **G 02 B 6/12**
**C 30 B 7/10, C 30 B 29/18**

(30) Priority: **12.06.85 GB 8514826**

(43) Date of publication of application:
**17.12.86 Bulletin 86/51**

(84) Designated Contracting States:
**DE FR IT NL**

(71) Applicant: **The General Electric Company, p.l.c.**
**1 Stanhope Gate**
**London W1A 1EH(GB)**

(72) Inventor: **Croxall, Derek Francis**
**18 Pickets Close**
**Bushey Heath Hertfordshire WD2 1NL(GB)**

(72) Inventor: **Isherwood, Brian James**
**19 Ilmington Road Kenton**
**Harrow Middlesex HA3 0NQ(GB)**

(72) Inventor: **Todd, Anthony Grieve**
**16 Woodside Road Bricket Wood**
**St. Albans Hertfordshire AL2 3QL(GB)**

(74) Representative: **Pope, Michael Bertram Wingate**
**Central Patent Department Wembley Office The General**
**Electric Company, p.l.c. Hirst Research Centre East Lane**
**Wembley Middlesex HA9 7PP(GB)**

(54) **Optical waveguides.**

(57) A method of producing an integrated optical waveguide by hydrothermal growth of an epitaxial layer of quartz doped with a refractive index modifying material on a predetermined crystal surface of a single crystal quartz substrate.

EP 0 205 284 A2

Optical Waveguides

This invention relates to integrated optical waveguides and methods of manufacturing the same.

Integrated optical waveguides are conventionally formed by producing a layer of waveguide material by diffusion or vapour deposition on a surface of a substrate. If desired part or parts of the layer may be subsequently removed, e.g. by selective etching, to form a waveguide of desired pattern. By varying the composition of the waveguide material layer on the substrate, the refractive index can be varied and, therefore, the waveguide modes supported by the waveguide for a particular wavelength or radiation can be controlled. Such integrated optical waveguides are used in the formation of integrated optical devices such as beam splitters/combiners, directional couplers or wavelength multiplexers/demultiplexers.

A particular problem with known techniques for producing integrated optical waveguides is good control of the composition and optical properties of the waveguide layer, in particular, obtaining a clean interface between the waveguide layer and the substrate.    It is an object of the present invention to provide a method of producing an integrated optical waveguide which alleviates this problem.

The present invention accordingly provides a method of forming an integrated optical waveguide comprising forming a layer of waveguide material on a surface of a substrate wherein said substrate comprises single crystal quartz with said surface at a predetermined orientation to a selected crystal axis of the quartz and said layer is formed by hydrothermal growth on said surface of an epitaxial layer of quartz doped with a refractive index modifying material.

Suitably germanium is used as the doping material for modifying the refractive index.

By virtue of the use of a hydrothermal growth technique very good control of the composition, physical structure and dimensions of the epitaxial layer, and hence of the waveguide is obtained, thus enabling the production of waveguides capable of transmitting high intensity radiation without damage and with low loss.

The technique of hydrothermal growth is well known and consists of the use of aqueous solvents under high temperature and high pressure to dissolve and recrystallize materials that are relatively insoluble under ordinary circumstances.    The technique is described, for example, at pages 231 to 251 (Chapter 13: Hydrothermal Growth) of a book entitled "The art and science of growing crystals" by Gilman, published in 1963 by Wiley which is thereby incorporated by reference.

The invention will now be further explained and two examples of methods in accordance with the invention described by way of example.

For the purposes of the present invention, hydrothermal growth may be carried out in any autoclave of suitable design. A platinum or other inert liner may be used in the autoclave to avoid contamination. Fused nutrient containing a source of doping material, e.g. germania, is crystallised in the autoclave in a suitable aqueous mineraliser, e.g. sodium, potassium or ammonium fluoride, under conditions of high temperature, of the order of 200 to $400^{\circ}C$, and pressure of the order of 1000 - 2000 Kg/cm$^2$. Typically the nutrient contains from 2 to 10 wt% of germania and the autoclave is filled to between 75% and 88% of its free volume with the aqueous mineraliser. Once the germania containing silica nutrient has been converted to germanium doped crystalline quartz by application of heat and pressure for a period e.g. in the region of 24 hours, the autoclave is opened and a planar quartz substrate having a polished surface or surfaces is suspended in the upper part of the autoclave. The autoclave containing the substrate is then sealed, repressurised and reheated, typically to between $225^{\circ}C$ and $350^{\circ}C$, for a period of time sufficient for a doped epitaxial quartz layer to be grown on the polished surface or surfaces of the substrate to the required thickness. Growth rates of between 1 and 26 microns per hour have been obtained depending on the crystal orientation of the polished major planes of the substrate.

The number of guide modes which can be excited in the epitaxial layer is a function of the layer thickness and refractive index change as well as the orientation of the substrate surface on which the epitaxial layer is deposited. The number of modes can be adjusted by polishing the layer after growth to the required thickness.

Use of a hydrothermal growth technique allows for good control of the thickness of the layer forming the waveguide, good control of the refractive index profile of the layer, and an interface between the layer and substrate which is very clean and well defined in that

-4-

very little, if any, disturbance of the quartz lattice structure occurs at the interface, and a sharp cut-off is present between the material containing and not containing dopant. The doping profile in the growth layer can be varied from a step function to a graded index by adjustment of the nutrient composition and control of the growth conditions, e.g. temperature and pressure and treatment time. The properties of the waveguide produced can also be varied by changing the orientation of the substrate on which the epitaxial layer is grown.

The following two examples of specific manufacturing methods further illustrate the use of the method of the present invention:-

Example 1

20 gms of silica doped with 7.5 per cent germania $(GeO_2)$ is placed at the bottom of a platinum lined autoclave with a 22 millimetre diameter bore which is 220 millimetres long. The autoclave is then filled with a two-mole potassium fluoride solution to 87 per cent of the free volume. The autoclave is sealed and heated to 275°C. This temperature is maintained for 24 hours. After cooling to room temperature the autoclave is opened and a quartz substrate with polished major surfaces oriented perpendicular to the Z(0001) axis, is suspended in the upper part of the autoclave. The autoclave is sealed and reheated to 275°C and held at that temperature for 1½ hours. After cooling and removal it is found that an epitaxial germania doped quartz layer of approximately 38 microns thickness has been deposited on each side of the substrate. After polishing the resulting optical waveguide is found to support eight guided modes of 0.6328 micron radiation such as produced by a helium/neon laser.

Example 2

The process of this example is generally similar to that described in respect of Example 1 except that the silica nutrient contains five per cent germania. The substrate in this example has major polished surfaces oriented perpendicular to the X($2\bar{1}\bar{1}0$) axis. The autoclave is sealed and reheated to 250°C for 16 hours. This results in a layer of approximately 18 microns thick on the + x side of the substrate only. After polishing, this layer is found to support three guided modes with 0.6328 micron radiation.

A further advantage of the method according to the invention is that it can be used with relatively large area substrates. The waveguides produced by this technique are found to have low loss due to their high structural perfection.

The above examples relate to particular crystal planes of the substrate. It will be appreciated that crystal growth will not take place on certain crystal planes and the rate of growth will vary in dependence on the crystal orientation of the polished major planes of the substrate.

As well as the use of germanium it would also be possible to use other known refractive index varying materials which are capable of being accepted in the crystal structure of quartz, e.g. iron. The degree of refractive index change can of course be varied by varying the amount of dopant added.

A further epitaxial layer of a different refractive index can be deposited over the first hydrothermally grown layer.

The resulting waveguide can be patterned for a specific purpose by known etching or similar techniques.

It will be appreciated that a method according to the invention may be used to form both passive waveguides and active waveguides, i.e. guides using the piezoelectric and electro optic properties of quartz.

CLAIMS

1.    A method of forming an integrated optical waveguide comprising forming a layer of waveguide material on a surface of a substrate characterised in that said substrate comprises single crystal quartz with said surface at a predetermined orientation to a selected crystal axis of the quartz and said layer is formed by hydrothermal growth on said surface of an epitaxial layer of quartz doped with a refractive index modifying material.

2.    A method as claimed in Claim 1, wherein the refractive index modifying material is germanium.

3.    A method as claimed in Claim 2, wherein the hydrothermal growth comprises the steps of crystallising a mixture of silica and germania in an aqueous mineraliser selected from the group comprising sodium fluoride, potassium fluoride and ammonia fluoride, in an autoclave under high temperature and pressure conditions, and suspending the substrate in the mineraliser under high temperature and pressure conditions for a sufficient period of time to deposit an epitaxial layer of the required thickness.

4.    A method according to Claim 3 wherein said high temperature is in the range 200 - 400$^{o}$C.

5.    A method according to Claim 3 or Claim 4 wherein said high pressure is in the range 1000 - 2000 Kg/cm$^2$.

6.    A method according to any one of Claims 3 to 5 wherein said mixture contains from 2 - 10 wt% of germania.

7.    A method according to any one of Claims 3 to 6 wherein said autoclave is filled to between 75% and 88% of its free volume with said aqueous mineraliser.

8.    A method according to any one of the preceding claims wherein said crystal axis is the Z(0001) axis and said surface is perpendicular to said axis.

0205284

-7-

9.      A method according to any one of Claims 1 to 7 wherein said axis is the X($2\bar{1}\bar{1}0$) axis and said surface is perpendicular to said axis.

10.      An integrated optical waveguide formed by a method according to any one of the preceding claims.